# EUROPEAN PATENT APPLICATION

(11) **EP 4 328 955 A1**
(43) Date of publication of application: **28.02.2024**
(21) Application number: 22791589.9
(22) Date of filing: 05.04.2022
(51) Int. Cl.: H01L 21/02, H01L 21/683, H01L 21/301

(54) **SHEET, THINNED WAFER HANDLING SHEET, THIN WAFER HANDLING METHOD, AND THIN DEVICE HANDLING METHOD**

(30) Priority: 21.04.2021 JP 2021072011
(71) Applicant: SHIN-ETSU CHEMICAL CO., LTD., Tokyo 1000005 (JP)
(72) Inventor: KATO, Hideto, Tokyo 100-0005 (JP); OOWADA, Tamotsu, Annaka-shi, Gunma 379-0224 (JP)
(74) Representative: Sonnenhauser, Thomas Martin
(86) International application number: PCT/JP2022/017084
(87) International publication number: WO 2022/224814

(57) **Abstract**

The present invention is a sheet including a plurality of structures, the structures being cylindrical or hemicylindrical structures with 50 microns to 500 microns in height and 10 microns to 1 mm in diameter or prismatic structures with 100 microns to 1 mm in length and 10 microns to 1 mm in thickness on a surface, wherein the sheet has a configuration in which the plurality of the structures are arranged with a same interval or a configuration in which the plurality of the structures are arrayed so that a maximum value of intervals is less than three times a minimum value of the intervals on the surface, and the sheet is molded with a thermosetting resin. This can provide: a sheet enabling to easily handle a thinned wafer and rearranged devices sealed with a mold and having excellent chemical resistance; a handling sheet for a thinned wafer including the sheet; and a method for handling a thin wafer using the handling sheet for a thinned wafer and a method for handling a thin device.

## Description

### TECHNICAL FIELD

The present invention relates to a sheet, a handling sheet for a thinned wafer, a method for handling a thin wafer, and a method for handling a thin device. The present invention specifically relates to a bonding sheet for handling a thin silicon wafer or a compound semiconductor wafer thinned to 300 microns or less, or a rectangular glass panel or a glass wafer with 1 millimeter or less without breakage.

### BACKGROUND ART

In recent years, semiconductor devices using a wafer thickness, which is conventionally more than 500 microns, of 300 microns or less, particularly 100 microns or less have been actively manufactured for increasing a density of the semiconductor devices.

For three-dimensional semiconductor devices, developed are manufacturing methods in which semiconductor devices using a wafer thickness of 300 microns or less, particularly 100 microns or less, are rearranged to a functionally required constitution on a glass panel thinned to 1 millimeter or less, particularly 500 microns or less, to form a package.

As for manufacturing such a thin wafer or package manufacturing using a thin panel, circuits are formed on both front and back surfaces of a silicon wafer and a through silicon via (TSV), a so-called through electrode, is formed to conduct the circuits in a through-silicon-via (TSV) process, which is an essential process for three-dimensional packaging of semiconductor elements, for example. To form this electrode, the silicon wafer to be the semiconductor device and a glass wafer for supporting, which is called a carrier, are bonded via a temporary glue, and then the thinning of the silicon wafer and the formation of the circuits are performed.

As for manufacturing a package using a thin panel, FPGA devices for AI or HBM elements, which are multistage stacked layer DRAM, are rearranged on a thin glass panel to constitute one function, for example. After the rearrangement of the elements on the glass panel, the panel is sealed with a mold resin, etc., then thinning and planarization are performed, and an electrode is exposed to form the circuits, etc.

In the two methods for handling a thin substrate described above, the silicon wafer or the glass wafer, which is a carrier, acts as a supporting base body to promote the process during the circuit formation. After the process, the silicon wafer thinned to 300 microns or less, or 100 microns or less in some cases, having formed circuits and the rearranged devices sealed with the mold are needed to be taken out.

These thinned silicon wafer and mold-sealed rearranged devices are conventionally taken out by using a dicing tape utilizing a UV-peeling method in common. In this method, commonly, the dicing tape is attached to the silicon wafer to be taken out in a state where the glass carrier is connected, and in this state, the carrier is removed by a laser-peeling method, etc.

However, the temporary glue resin used in the thinning process typically remains on a surface of the thinned circuit-formed silicon wafer thus taken-out and attached on the dicing tape.

This remained resin is needed to be dissolved by a solvent-washing method, etc. to be removed.

Meanwhile, the glue for bonding in the dicing tape uses an uncured acrylic resin, etc. in many cases. It is known that the glue is dissolved in a solvent used in a solvent-washing step of the remained resin in this temporary glue, and causes problems such as peeling and swelling. Thus, this glue has a problem of strictly limited usable solvent for washing.

Patent Document 1 discloses an invention about a dry adhesive fiber structure having microfibers with a mushroom-shaped tip.

### CITATION LIST

### PATENT LITERATURE

Patent Document 1: US 2015/0368519 A1

### SUMMARY OF INVENTION

### TECHNICAL PROBLEM

In the aforementioned circumstances, there have been demands for development of a tool for the conventional thinning process for a silicon wafer and a compound semiconductor widely used for a purpose of the aforementioned three-dimensional packaging, etc., the tool enabling to easily handle the thinned wafer and the rearranged devices sealed with a mold, and having excellent chemical resistance.

The present invention has been made to solve the above problems. An object of the present invention is to provide: a sheet enabling to easily handle the thinned wafer and the rearranged devices sealed with a mold, and having excellent chemical resistance; a handling sheet for a thinned wafer comprising the sheet; and a method for handling a thin wafer using the handling sheet for a thinned wafer and a method for handling a thin device.

### SOLUTION TO PROBLEM

To solve the above problems, the present invention provides a sheet comprising a plurality of structures, the structures being cylindrical or hemicylindrical structures with 50 microns to 500 microns in height and 10 microns to 1 mm in diameter or prismatic structures with 100 microns to 1 mm in length and 10 microns to 1 mm in thickness on a surface, wherein the sheet has a configuration in which the plurality of the structures are arranged with a same interval or a configuration in which the plurality of the structures are arrayed so that a maximum value of intervals is less than three times a minimum value of the intervals on the surface, and the sheet is molded with a thermosetting resin.

Such a sheet enables to easily bond a wafer with a sufficient bonding force, and to be peeled with little force. Thus, the thinned wafer or the rearranged devices sealed with a mold can be easily handled without breakage.

Furthermore, since the inventive sheet is formed with a thermosetting resin and having excellent chemical resistance, various resins for washing a temporary glue can be used.

The thermosetting resin is, for example, at least one selected from the group consisting of an acrylic thermosetting elastomer, a silicone-based thermosetting elastomer, an urethane-based thermosetting elastomer, and a fluorine-based thermosetting elastomer.

Using such a thermosetting elastomer as the thermosetting resin achieves a sheet having more excellent chemical resistance.

The present invention also provides a handling sheet for a thinned wafer comprising:
a base body; and
the inventive sheet laminated on the base body.

Since such a handling sheet for a thinned wafer comprises the inventive sheet, the thinned wafer or the rearranged devices sealed with a mold can be easily handled without breakage.

Furthermore, by using the inventive handling sheet for a thinned wafer, the bonding portion thereof has excellent chemical resistance by using the thermosetting elastomer, and thereby various resins for washing a temporary glue can be used.

The present invention also provides a method for handling a thin wafer, wherein a silicon wafer or a compound semiconductor wafer with 300 microns or less in thickness is handled with bonding to the inventive handling sheet for a thinned wafer.

Since the inventive method for handling a thin wafer requires little force for peeling, a silicon wafer even with 300 microns or less in thickness can be easily taken out without breakage.

The present invention also provides a method for handling a thin device, wherein a rectangular glass panel or a metal panel with 1.5 millimeters or less in thickness is handled with bonding to the inventive handling sheet for a thinned wafer, a silicon wafer or a compound semiconductor wafer with 300 microns or less in thickness being mounted on the rectangular glass panel or the metal panel.

Since the inventive method for handling a thin device requires little force for peeling, a rectangular glass panel or a metal panel even with 1.5 millimeters or less in thickness can be easily taken out without breakage, a silicon wafer or a compound semiconductor wafer with 300 microns or less in thickness being mounted on the rectangular glass panel or the metal panel.

### ADVANTAGEOUS EFFECTS OF INVENTION

As noted above, the inventive sheet enables to easily bond a wafer with a sufficient bonding force and requires little force for peeling, and thereby the thinned wafer or the rearranged devices sealed with a mold can be easily handled without breakage. In addition, since the inventive sheet is formed with a thermosetting resin and having excellent chemical resistance, various resins for washing a temporary glue can be used.

Furthermore, the inventive handling sheet for a thinned wafer comprises the inventive sheet, and thereby the thinned wafer or the rearranged devices sealed with a mold can be easily handled without breakage. Furthermore, using the inventive handling sheet for a thinned wafer enables the bonding portion to have excellent chemical resistance by using the thermosetting elastomer, and thereby various resins for washing a temporary glue can be used. Therefore, the inventive handling sheet for a thinned wafer is particularly usefully used in a method for handling a thin wafer and a method for handling a thin device, for example.

Since the inventive method for handling a thin wafer requires little force for peeling, a silicon wafer even with 300 microns or less in thickness can be easily taken out without breakage.

Since the inventive method for handling a thin device requires little force for peeling, a rectangular glass panel or a metal panel even with 1.5 millimeters or less in thickness can be easily taken out without breakage, a silicon wafer or a compound semiconductor wafer with 300 microns or less in thickness being mounted on the rectangular glass panel or the metal panel.

### BRIEF DESCRIPTION OF DRAWINGS

FIG. 1 is a schematic sectional view illustrating an example of the inventive sheet.
FIG. 2 is a schematic sectional view illustrating an example of the inventive handling sheet for a thinned wafer.
FIG. 3 is a schematic sectional view illustrating an example of a use portion of the inventive handling sheet for a thinned wafer.

### DESCRIPTION OF EMBODIMENTS

As noted above, there have been demands for development of a tool for the thinning process for a silicon wafer and a compound semiconductor widely used for a purpose of the aforementioned three-dimensional packaging, etc., the tool enabling to easily handle the thinned wafer and the rearranged devices sealed with a mold, and having excellent chemical resistance.

The present inventors have been made earnestly studied the above problem, and consequently found that a wafer can be easily bonded with a sufficiently bonding force and a thinned wafer or rearranged devices sealed with a mold can be easily handled without breakage because of a required little force for peeling, and excellent chemical resistance can be exhibited with a sheet comprising a plurality of structures, the structures being cylindrical or hemicylindrical structures with 50 microns to 500 microns in height or prismatic structures with 100 microns to 1 mm in length and a thickness of 10 microns to 1 mm in thickness, on a surface, wherein the sheet has a configuration in which these are arranged with a same interval or a configuration in which these are arrayed so that a maximum value of intervals is less than three times a minimum value of the intervals on the surface, and the sheet is molded with a thermosetting resin. This finding has led to complete the present invention.

Specifically, the present invention is a sheet comprising a plurality of structures, the structures being cylindrical or hemicylindrical structures with 50 microns to 500 microns in height and 10 microns to 1 mm in diameter or prismatic structures with 100 microns to 1 mm in length and 10 microns to 1 mm in thickness on a surface, wherein the sheet has a configuration in which the plurality of the structures are arranged with a same interval or a configuration in which the plurality of the structures are arrayed so that a maximum value of intervals is less than three times a minimum value of the intervals on the surface, and the sheet is molded with a thermosetting resin.

In addition, the present invention is a handling sheet for a thinned wafer comprising:
a base body; and
the inventive sheet laminated on the base body.

In addition, the present invention is a method for handling a thin wafer, wherein a silicon wafer or a compound semiconductor wafer with 300 microns or less in thickness is handled with bonding to the inventive handling sheet for a thinned wafer.

In addition, the present invention is a method for handling a thin device, wherein a rectangular glass panel or a metal panel with 1.5 millimeters or less in thickness is handled with bonding to the inventive handling sheet for a thinned wafer, a silicon wafer or a compound semiconductor wafer with 300 microns or less in thickness being mounted on the rectangular glass panel or the metal panel.

Hereinafter, the present invention will be described in detail, but the present invention is not limited thereto.

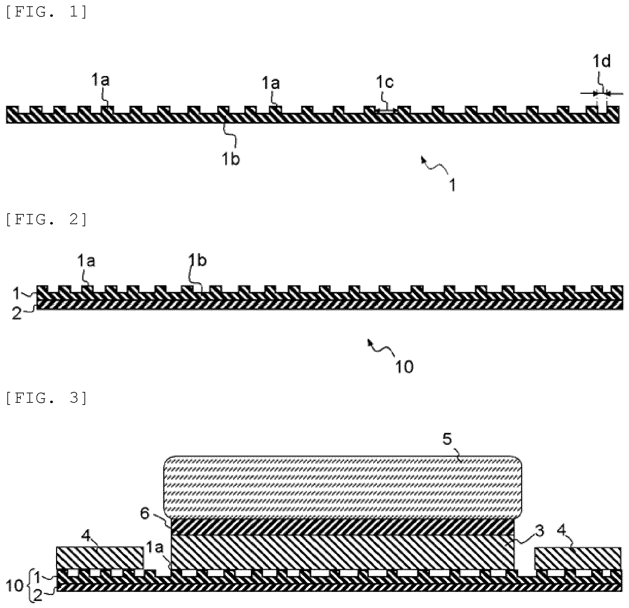

FIG. 1 is a schematic sectional view illustrating an example of the inventive sheet. A sheet 1 illustrated in FIG. 1 has a plurality of structures 1a on one surface of a base 1b made of a resin. The sheet 1, namely the plurality of the structures 1a and the base 1b are molded with a thermosetting resin.

The resin used in the present invention is composed of the thermosetting resin. Specifically, a thermosetting elastomer, more specifically at least one selected from the group consisting of an acrylic thermosetting elastomer, a silicone-based thermosetting elastomer, an urethane-based thermosetting elastomer, and a fluorine-based thermosetting elastomer is used, for example.

These resins are preferably moldable into a shape described below and preferably does not cause transfer of the resin component when peeled from a bonding target, but the range and use thereof are not limited.

The inventive sheet 1 has fine structures 1a, specifically a plurality of structures 1a, the structures 1a being cylindrical or hemicylindrical structures with 50 microns to 500 microns in height and 10 microns to 1 mm in diameter or prismatic structures with 100 microns to 1 mm in length and 10 microns to 1 mm in thickness, on a surface of the resin (base 1b). Should be noted that in the present invention, when the structure 1a has a prismatic shape, the thickness thereof refers to a diameter of a circumscribed circle of a cross section of the structure 1a. The sheet 1 has a configuration in which the plurality of the structures 1a are arranged with a same interval or a configuration in which the plurality of the structures 1a are arrayed so that a maximum value 1c of intervals is less than three times a minimum value 1d of the intervals on the surface. The maximum value 1c of the intervals is larger than the minimum value 1d of the intervals.

As illustrated in FIG. 2, this sheet 1 is typically subjected to use with a shape laminated to a film (base body 2) such as a PET or polyolefin resin sheet.

A laminated sheet 10 can be used as a handling sheet for a thinned wafer, for example. The handling sheet 10 for a thinned wafer illustrated in FIG. 2 comprises the base body 2 and the inventive sheet 1 laminated on the base body 2. The sheet 1 illustrated in FIG. 2 has the same configuration as of the sheet 1 illustrated in FIG. 1.

The structures 1a of the sheet 1 generated on the base body 2, such as the resin sheet, preferably have a uniform height and a plane surface of the structures. A size and pitch thereof (dimensions of the structure 1a and the interval between the structures 1a) can be freely selected, but can desirably hold the bonding target, such as for example, a silicon wafer or a compound semiconductor wafer having formed circuits.

Next, use examples of the inventive handling sheet 10 for a thinned wafer will be described.

FIG. 3 is a schematic sectional view illustrating an example of a use portion of the inventive handling sheet for a thinned wafer.

A part of the surface of the plurality of the structures 1a on the sheet 1 of the handling sheet 10 for a thinned wafer is bonded to, for example, a frame such as a dicing frame (for example, a metal frame) 4, and then a processed thinned wafer (for example, a silicon wafer or a compound semiconductor wafer) 3 with a carrier 5 is bonded by the other part of the surface of the plurality of the structures 1a. The thinned wafer 3, which is the bonding target, is temporarily bonded to the carrier 5 via a temporary glue layer 6 containing a temporary glue. Thereafter, the carrier 5, for example a glass wafer, is peeled by a laser-peeling method, etc. according to a property of the temporary glue in the temporary glue layer 6. After the carrier 5 is peeled, a residue of the temporary glue remained on the thinned wafer 3 is washed with an appropriate organic solvent-based washing agent to be able to take out the thinned wafer 3 bonded on the inventive handling sheet 10 for a thinned wafer. Since being molded with the thermosetting resin, the inventive sheet 1 has high chemical resistance. Therefore, in the handling method using the inventive sheet 1, various solvents and resins for washing the temporary glue can be used in order to remove the residue of the temporary glue.

Via the above steps, the thinned wafer 3 laminated to the handling sheet 10 for a thinned wafer can be obtained. The bonding between the handling sheet 10 for a thinned wafer and the thinned wafer 3 can exhibit necessary and sufficient strength durable for handling by virtue of the presence of the plurality of the structures 1a on the surface of the sheet 1. Meanwhile, the thinned wafer 3 can be easily taken out of the handling sheet 10 for a thinned wafer after the handling by, for example, applying a weak force to an edge portion of the wafer. This peeling requires little force because of the plurality of the structures 1a formed on the surface of the handling sheet 10 for a thinned wafer, and a 300-mm silicon wafer 3 even with 300 microns or less in thickness, particularly 30 microns or less in thickness, can be easily taken out without breakage.

Since the resin is not transferred to the surface, an additional washing step is unnecessary after the thinned wafer 3 is taken out.

As above, the inventive handling sheet 10 for a thinned wafer can be used in, for example, the method for handling a thin wafer, which handles a silicon wafer or a compound semiconductor wafer 3 with 300 microns or less in thickness. In the inventive method for handling a thin wafer, the silicon wafer or the compound semiconductor wafer 3 can be handled with bonding to the inventive handling sheet 10 for a thinned wafer. Accordingly, even the silicon wafer or the compound semiconductor wafer 3 with 300 microns or less in thickness can be easily taken out without breakage.

Meanwhile, if the plurality of the structures 1a are cylindrical or hemicylindrical structures with less than 50 microns in height, more than 500 microns in height, less than 10 microns in diameter, or more than 1 mm in diameter, at least one of the bonding force required for handling and the excellent peeling easiness cannot be achieved. Similarly, if the plurality of the structures 1a are prismatic structures with less than 100 microns in length, more than 1 mm in length, less than 10 microns in thickness, or more than 1 mm in diameter, at least one of the bonding force required for handling and the excellent peeling easiness cannot be achieved.

If the plurality of the structures 1a are arrayed so that the maximum value of the intervals is more than three times the minimum value of the intervals, the bonding force required for handling cannot be exhibited.

In the present invention, when the sheet 1 which is a processed product with a target shape from the thermosetting resin, preferably the thermosetting elastomer, more preferably the acrylic, silicone-based, urethane-based, or fluorine-based thermosetting elastomer and the sheet 1 is bonded to the thinned wafer, the handling sheet 10 for a thinned wafer having excellent chemical resistance and other process applicability can be formed.

The use of the inventive handling sheet 10 for a thinned wafer is not limited to the method for handling a thin wafer. For example, the inventive handling sheet 10 for a thinned wafer can also be used in a method for handling a thin device. In the inventive method for handling a thin device, a rectangular glass panel or a metal panel on which, for example, a silicon wafer or a compound semiconductor wafer with 300 microns or less in thickness is mounted and which has a thickness of 1.5 millimeters or less can be handled with boding to the inventive handling sheet for a thinned wafer. Accordingly, even the rectangular glass panel or the metal panel on which, for example, a silicon wafer or a compound semiconductor wafer with 300 microns or less in thickness is mounted and which has a thickness of 1.5 millimeters or less can be easily handled without breakage.

A lower limit of the thickness of the silicon wafer or the compound semiconductor wafer handled by bonding to the inventive handling sheet 10 for a thinned wafer is not particularly limited. For example, a silicon wafer or a compound semiconductor wafer with 10 microns or more and 300 microns or less in thickness can be handled. A lower limit of the thickness of the prismatic glass panel or the metal panel handled by bonding to the inventive handling sheet 10 for a thinned wafer is also not particularly limited. For example, a rectangular glass panel or a metal panel on which a silicon wafer or a compound semiconductor wafer with 10 microns or more and 300 microns or less in thickness and which has a thickness of 0.1 millimeter or more and 1.5 millimeters or less can be handled.

### EXAMPLE

Hereinafter, the present invention will be specifically described by using Example, but the present invention is not limited thereto.

### [Example]

On a PET sheet with 100 microns in thickness, cylindrical structures with 200 microns in height and 500 microns in diameter were molded so that intervals thereof were 500 microns (same intervals) and a total thickness was 500 microns. The structures were molded with an urethane resin, which was a thermosetting elastomer. Thus, a handling sheet for a thinned wafer was obtained.

Meanwhile, a 300-mm glass wafer (700 microns in thickness) was used as a carrier, and on this glass carrier, a UV-laser peeling temporary material (SPIS-TA401 + SPIS-TA501), manufactured by Shin-Etsu Chemical Co., Ltd., was used as a temporary glue layer, a wafer with 775 microns in thickness and having formed TSV was bonded. Then, the wafer having the formed TSV was thinned to 50 microns in thickness, a terminal of TSV was formed, and a SiO₂ film was formed with plasma CVD using TEOS to obtain a thinned silicon wafer. On this thinned silicon wafer, the handling sheet for a thinned wafer obtained as above having a formed dicing frame was laminated.

A front surface of this laminate composed of the glass carrier, the temporary glue layer, the thinned silicon wafer, and the handling sheet for a thinned wafer was irradiated with UV laser from firstly a side of a surface of the glass carrier to peel the glass carrier. Thereafter, a residue of the temporary glue resin remained on the silicon wafer was dissolved and washed with a cleaner SPIS-TA-Cleaner-25, manufactured by Shin-Etsu Chemical Co., Ltd.

In this time, abnormality such as separation and floating was not observed on the handling sheet for a thinned wafer supporting the thinned silicon wafer. That is, the bonding between the handling sheet for a thinned wafer and the thinned silicon wafer exhibited sufficient strength durable for handling the thin wafer.

Finally, the sheet was peeled from a back surface of the handling sheet for a thinned wafer from an edge portion of the thinned silicon wafer. Thus, the sheet was easily peeled, the wafer with 50 microns in thickness had no damage such as cracking, and the glue of the resin was not remained.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A sheet, comprising a plurality of structures, the structures being cylindrical or hemicylindrical structures with 50 microns to 500 microns in height and 10 microns to 1 mm in diameter or prismatic structures with 100 microns to 1 mm in length and 10 microns to 1 mm in thickness on a surface, wherein
the sheet has a configuration in which the plurality of the structures are arranged with a same interval or a configuration in which the plurality of the structures are arrayed so that a maximum value of intervals is less than three times a minimum value of the intervals on the surface, and
the sheet is molded with a thermosetting resin.

2. The sheet according to claim 1, wherein the thermosetting resin is at least one selected from the group consisting of an acrylic thermosetting elastomer, a silicone-based thermosetting elastomer, an urethane-based thermosetting elastomer, and a fluorine-based thermosetting elastomer.

3. A handling sheet for a thinned wafer, comprising:
a base body; and
the sheet according to claim 1 or 2 laminated on the base body.

4. A method for handling a thin wafer, wherein a silicon wafer or a compound semiconductor wafer with 300 microns or less in thickness is handled with bonding to the handling sheet for a thinned wafer according to claim 3.

5. A method for handling a thin device, wherein a rectangular glass panel or a metal panel with 1.5 millimeters or less in thickness is handled with bonding to the handling sheet for a thinned wafer according to claim 3, a silicon wafer or a compound semiconductor wafer with 300 microns or less in thickness being mounted on the rectangular glass panel or the metal panel.
